# EUROPEAN PATENT APPLICATION

(11) **EP 0 640 880 A1**
(43) Date of publication of application: **01.03.1995**
(21) Application number: 94305903.0
(22) Date of filing: 10.08.1994
(51) Int. Cl.: G03F 9/00

(54) **Alignment of wafers for lithographic patterning**

(30) Priority: 18.08.1993 US 108464
(71) Applicant: AT&T Corp., New York, NY 10013-2412 (US)
(72) Inventor: Ryan, John L., Hampton, New Jersey 08827 (US); Stone, Douglas Roy, Coopersburg, Pennsylvania 18036 (US); Yang, Tungsheng, Wescosville, Pennsylvania 18106 (US)
(74) Representative: Johnston, Kenneth Graham

(57) **Abstract**

Small and closely spaced features (5) are used for global and local alignment during lithographic patterning. The features (5) are sufficiently small so that the spun on resist (9) has an approximately planar surface over the features (5) thereby eliminating errors in measuring position caused by variations in optical thickness of the resist (9). Such variations lead to shifts in the apparent locations of the features (5) when the intensity of reflected radiation is measured.

## Description

### Technical Field

This invention relates generally to methods for integrated circuit manufacturing which includes aligning wafers for lithographic patterning and particularly to methods using features on the wafers for alignment and to the patterned substrate.

### Background of the Invention

Integrated circuit fabrication requires a plurality of lithographic patterning steps in which selected portions of a resist covered substrate are exposed to radiation transmitted through a mask at each patterning step. The resist, which is a radiation sensitive material, is then processed and selected portions removed to expose the underlying substrate. Whether the exposed or unexposed portions of the resist are removed depends upon whether the resist is a positive or negative resist, respectively. The radiation used for patterning features having submicron dimensions is, for example, ultraviolet radiation. Further processing of the now exposed portions of the substrate, for example, etching, cleaning, or ion implantation, is then performed. The term "substrate" is used to mean any material that lies underneath and supports another material. The substrate may thus be an upper level metal, etc. Device fabrication, of course, requires that each patterning step or level be accurately aligned with respect to the preceding step on the wafer. The requirements for alignment accuracy increase as device dimensions decrease. Satisfaction of alignment requirements is made more difficult because each wafer has many chips; each step must be accurately aligned with respect to the preceding step for each chip. The projected image for each level comes from a stepper, and the projected image must be precisely moved from chip to chip for accurate pattern transfer.

Methods for aligning the wafer with respect to the projected image from the stepperfor patterning have been developed. Many of these methods require a determination of two or more positions on the substrate. This is frequently done by fabricating features, such as islands ortrenches in the top layer or in a layer near the top layer, and spinning on resist which covers the features. The wafer is then illuminated with a radiation source, either broad or narrow band, and the reflected or scattered light intensity measured from different positions on the wafer. The intensity of the reflected radiation varies because of the presence of the features; in particular, there is a minimum in intensity near the edges of the features. Measurement of the reflected intensity as a function of position on the wafer theoretically permits the features to be precisely located because determination of the minima permits the center of the feature to be located. Measurement of at least two, and frequently more, positions permits the scaling, that is, the difference between the measured and design distance divided by the design difference, to be determined. The scaling is frequently not zero because the wafer either expands or contracts during processing. Determination of the scaling is necessary so that the stepper may be adjusted to have the proper stepping distance to move the image the correct distance for each exposure. Additionally, the magnification of the stepper may have to be adjusted. The adjustment may be done either automatically or manually.

However, in practice, the features are not located precisely by this method. The method assumes that the optical conditions are constant for a given feature; that is, in particular, it assumes that the resist has a constant optical thickness everywhere on the feature and that the reflectivity from underlying material, such as a metal, is constant The resist is typically spun on and the centripetal force exerted on the resist and the features result in the resist having a non-uniform optical thickness over the features. In particular, the resist thicknesses at the opposed sides of the features are different and the center of the signals indicating the reflected light intensity, apparently indicating the center of the feature, is therefore not precisely located. If the top layer is a metal, the metal coverage of the feature may not be symmetrical. The metal may also have a relatively large grain size which complicates analysis of the reflection radiation. Thus, both the metal coverage and the grain size may make determination of feature position difficult. The uncertainty in feature location makes precise determination of the stepping distance and the stepper magnification extremely difficult.

The determination of the scaling and the size of the scaling error are important considerations in integrated circuit design. This is particularly true for metal levels where measurement of the scaling is difficult due to the high metal reflectivity. Smaller scaling errors permit tighter design rules which, in turn, permit smaller chip sizes. The scaling error is desirably less than 1 part per million for fabrication of features having 0.5 micron or smaller dimensions.

### Summary of the Invention

An integrated circuit manufacturing process locates positions on a wafer by forming features on the wafer and spinning on a resist that covers the wafer and the features. The wafer is then illuminated with radiation and the intensity of the reflected radiation measured as a function of position thereby permitting the locations of the features to be accurately determined. The features, which are desirably widely spaced from each other, have a dimension sufficiently small so that the surface of the resist is symmetric over the features. The dimension is desirably less than 0.8f,.lm. That is, the surface is approximately planar. The features are typically formed in a dielectric. A metal layer may be deposited on the dielectric before the resist is spun on. The approximately planar surface insures that the resist or metal has symmetric optical properties over the features. That is, the reflected radiation has equal intensity from identical portions of the features. The illumination from the radiation source may be either broad or narrow band. The scaling is then determined from the feature locations and the scaling error may be small, less than 1 part per million, because the locations of the features are accurately measured. After the scaling and scaling error have been determined, these factors are used to adjust the stepping distance, that is, the distance the stepper image moves as successive images are exposed, and may also be used to adjust the stepper magnification.

In a preferred embodiment, the feature is a moat that has two closely spaced parallel trenches when a cross section of the feature is examined. Each trench can be accurately located as can the midpoint between the trenches. The scaling is then measured with an extremely small scaling error.

Another aspect of the invention is the substrate with the features; that is, a substrate having a plurality of features having dimensions sufficiently small so that surface tension maintains an approximately planar surface in spun on resist.

### Brief Description of the Drawing(brief

FIG. 1 is a sectional view of a portion of an integrated circuit, including features used to measure location, during manufacturing according to this invention;
FIG. 2 is a top view of the portion of the integrated circuit depicted in FIG. 1 showing the features used to measure location;
FIG. 3 is a sectional view of a portion of an integrated circuit, including features used to measure location and a metal layeroverthe feature, during manufacturing according to this invention.
FIG. 4 is a sectional view of a prior art feature; and
FIGs. 5 and 6 are plots of the intensity of the intensity of the reflected radiation from the features depicted in FIGs. 3 and 4, respectively.

For reasons of clarity, the elements depicted are not drawn to scale.

### Detailed Description

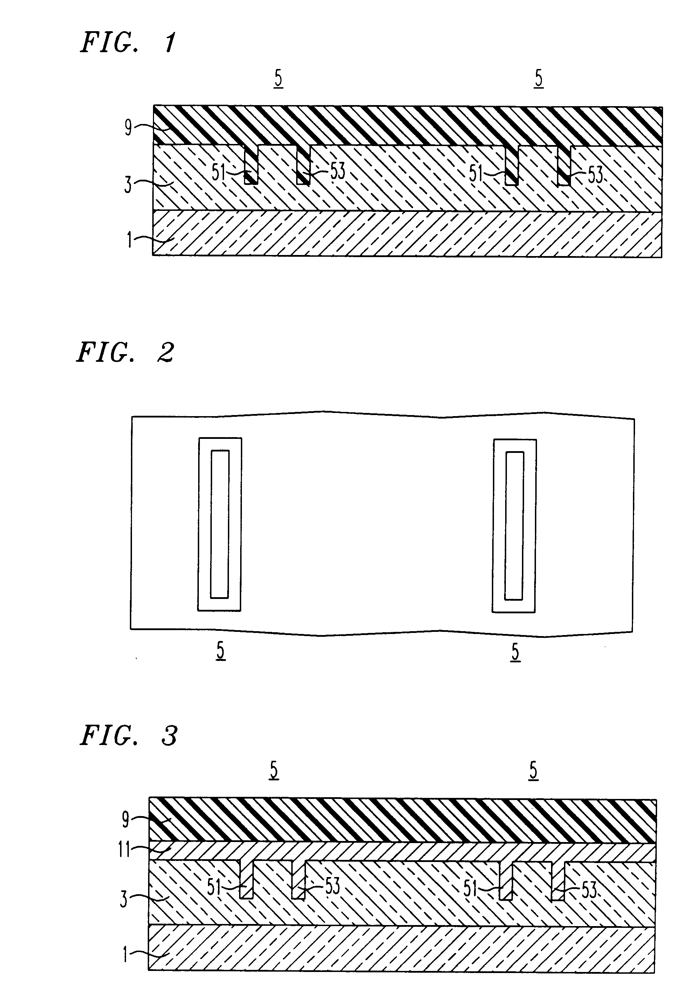

The invention will be described by reference to a particular embodiment. Depicted in FIG. 1 is a side view of a portion of an integrated circuit according to this invention. The integrated circuit includes features useful in determining the positions of the features and, thereby the scaling, on the wafer. It is contemplated that the features may be left on the chip after processing is completed, but will not form a part of the electrical circuit. Depicted are substrate 1, layer 3, plurality of features 5, and resist layer 9. Features 5 are formed in layer 3 and each feature has two closely spaced trenches 51 and 53. In typical practice, features are fabricated in groups with a plurality of features in each group. For reasons of clarity, only a single feature is shown for each group. Of course, more than two groups of features may be present. The two features 5 are widely separated from each other on the wafer; their separation is large enough so that the scaling may be accurately measured. The term "substrate" is used to mean any material that lies underneath and supports another layer. The substrate may be silicon, a dielectric atany level of the integrated circuit fabrication process, or any of the other materials commonly used in integrated circuit fabrication. A metal will be discussed with respect to FIG. 3. The material of layer 3 is also one of the materials used in integrated circuit manufacturing that will have selected portions processed after the resist has been patterned. It is evident from the side view that the resist has a flat or planar surface over each feature. That is, the resist surface is symmetric with respect to the feature. This is because of the relatively sound dimension of the feature; that is, the feature should be sufficiently small so that the surface of the resist is symmetric over the feature. The dimension is desirably less than 0.8µm. Absolute symmetry is, of course, not required because at some small dimension deviations from planarity or symmetry will be present. Symmetry means that the feature can be accurately located by analysis of the reflected radiation. Global planarity, that is a planar resist surface over the entire wafer, is not required; all that is required for the practice of this invention is local planarity over the features. This insures that the resist has a symmetric optical thickness over each feature.

A top view of the portion of the integrated circuit depicted in FIG. 1 is depicted in FIG. 2. The top view shows that the features may be more precisely termed islands. The device elements of the integrated circuit are not shown for reasons of clarity. Such elements are well known to those skilled in the art and need not be depicted for an understanding of the invention. The features depicted are used for alignment purposes, that is, to determine the stepping distance, and are typically located on the periphery of the integrated circuit.

FIG. 3 shows another embodiment with metal layer 7 present between layer 3 and resist layer 9. Layer 7 is symmetric with respect to features 5.

The structures depicted will be readily fabricated by those skilled in the art. The precise dimensions of the features are not critical. However, the trenches must have a transverse dimension sufficiently small so that the resist has an approximately planar surface. That is, the resist surface must not mimic the underlying surface topography as it did with the described prior art. Those skilled in the art will readily select such dimensions. The dimension is desirably less than 0.8f,.lm. The trenches may be sufficiently narrow that their edges are not resolved by the radiation used for measurement. Well known and conventional techniques are used to spin on the resist.

The positions of at least two features in at least two groups are measured by illuminating the wafer with radiation and measuring the intensity of the reflected radiation. The wavelength of the radiation is not critical; however, the radiation should pass through the resist without further exposure, that is, without further chemical or physical reactions in the resist. Well known equipment and techniques are used to measure the positions of the features. Alignment sites are on the wafer and their locations are programmed into the computer that controls the stepper with the coordinate of the marks and the step and repeat distance. The stepper measures the real location and calculates items including scaling (due to wafer expansion or contraction) and any offset (translation). Other items, such as rotation of the wafer with respect to the projected image, may also be calculated. Typically, the edges of the features are used to determine the middle of the feature. The position of the middle is then used to determine the scaling. After the positions of the features have been determined, the scaling is determined. The scaling is the difference between the measured and design distance divided by the design distance. After the scaling has been determined, it is used to adjust the stepping distance, that is, the distance the stepper image moves are successive images are exposed.

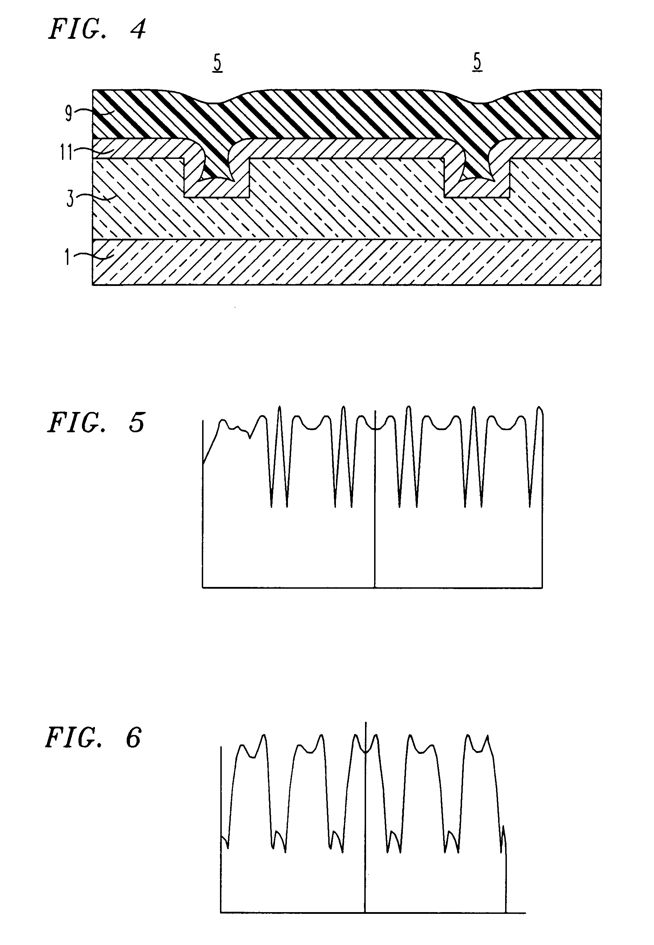

A typical prior art feature is depicted in sectional view in FIG. 4. The feature is trench 11. However, trench 11 is considerably wider than are the trenches depicted in FIG. 1; the width of the trench depicted is approximately the same is as the separation between the trenches depicted in FIG. 1. A metal layer 11 is present as it was in FIG. 3. This width is sufficiently large so that surface tension does not maintain an approximately planar resist surface as shown. The lack of a planar resist surface makes precise determination of feature position on the substrate surface difficult due to the varying optical thickness of the resist.

This is better understood by consideration of FIGs. 5 and 6 which show the intensity of the reflected radiation for the structures depicted in FIGS. 3 and 4, respectively. The dimension of the trench was 0.6f,.lm. The radiation used was the 612 ± 20 nm radiation from a mercury-halogen lamp. Such lamps are well known and readily used. An appropriate wavelength will be readily selected by those skilled in the art after consideration of parameters such as feature dimension and the optical properties of the materials. The techniques used to scan the wafer with radiation and measure the intensity of the reflected radiation are well known and need not be described further. As can be seen in FIG. 5, the trenches of FIG. 3 yield very sharp peaks which are between the minima produced by the edges. As can be seen in FIG. 6, the trenches of FIG. 4 yield very poorly defined peaks representing the centers of the trench. Accordingly the trench, and therefore the center of the island, cannot be accurately located. The scaling errors were measured as 0.0 and 0.8 parts per million for FIGs 5 and 6, respectively. The error in the measurement was estimated to be less than 0.02 parts per million. The smaller error will permit the use of tighter design rules.

Another aspect of the invention is the wafer and the individual integrated circuit chips with the alignment marks.

Variations in the embodiment described will be readily imagined by those skilled in the art. For example, narrow band radiation or radiation at a wavelength different from that described may be used.

## Claims

1. A method of integrated circuit manufacturing comprising the steps of:
forming features (5) on a substrate (1);
spinning on a resist (9) to cover said features (5) on said substrate (1), said features (5) being sufficiently small so that the resist surface is symmetric over the features (5);
illuminating said resist (9) covered substrate (1) with radiation;
measuring the intensity of the radiation reflected from the substrate (1) as a function of position;
determining the scaling factor by measuring the positions of at least two features; and
adjusting the stepping distance of the stepper.

2. A method as recited in claim 1 in which said features (5) comprise a plurality of islands.

3. A method as recited in claim 2 in which said radiation is broad band.

4. A method as recited in claim 2 in which said radiation is narrow band.

5. A method as recited in claim 2 in which said substrate (1) comprises a dielectric.

6. A method as recited in claim 1 comprising the further step of adjusting the magnification of the stepper.

7. A method as recited in claim 1 in which said features (5) have a dimension less than 0.8µm.

8. A device comprising a silicon substrate (1); at least one layer (3) of material on said substrate (1); at least one feature (5) in said layer (3), said feature (5) being sufficiently small so that a deposited resist (9) has an approximately planar surface.

9. A device as recited in claim 8 comprising at least two features (5) on said substrate (1).

10. A device as recited in claim 8 in which said feature (5) has a dimension less than 0.8µm.
